**Europäisches Patentamt**

**European Patent Office**

**Office européen des brevets**

(19)

(11) Publication number: **0 174 949**
**B1**

(12) # EUROPEAN PATENT SPECIFICATION

(45) Date of publication of patent specification: **15.06.88**

(51) Int. Cl.⁴: **B 29 D 17/00, B 23 B 27/08**

(21) Application number: **85901246.0**

(22) Date of filing: **19.02.85**

(86) International application number:
**PCT/US85/00267**

(87) International publication number:
**WO 85/03669 29.08.85 Gazette 85/19**

(54) METHOD AND APPARATUS FOR LAMINATING FLEXIBLE PRINTED CIRCUITS.

(30) Priority: **22.02.84 US 582303**

(43) Date of publication of application:
**26.03.86 Bulletin 86/13**

(45) Publication of the grant of the patent:
**15.06.88 Bulletin 88/24**

(84) Designated Contracting States:
**CH DE FR GB LI SE**

(56) References cited:
**FR-A-2 164 823**
**FR-A-2 230 497**
**US-A-3 649 475**
**US-A-3 932 250**
**US-A-4 075 386**
**US-A-4 224 378**
**US-A-4 264 404**
**US-A-4 350 551**
**US-A-4 461 800**

(73) Proprietor: **GILA RIVER PRODUCTS, INC.**
**6615 West Boston Street**
**Chandler, AZ 85224 (US)**

(72) Inventor: **KLOSS, Thomas, M., Jr.**
**1815 E. LaVieve Lane**
**Tempe, AZ 85284 (US)**

(74) Representative: **Schmitz, Jean-Marie et al**
**OFFICE DENNEMEYER S.à.r.l. P.O. Box 1502**
**L-1015 Luxembourg (LU)**

Courier Press, Leamington Spa, England.

**Description**

The present invention concerns a stratiform sheet for use in the flat press method of laminating three-dimensional printed circuits comprising a polymeric thermoplastic layer having a glass transition point lower than the laminating temperature peak and a melting point higher than the laminating temperature peak, a method of laminating printed circuits under pressure and heat in a flat press and a charge of material for a flat bed press pad useful in printed circuit lamination comprising a printed circuit assembly and a stratiform sheet according to the present invention.

In the manufacture of flexible and flat cable circuits, layers of high dielectric strength plastic films with low shrinkage and good stability at high temperatures are first combined with copper or other conductive metal by an additive or substractive process and electrical circuits are produced by etching or deposition of these metals on the plastic surface. The circuits are then covered by a layer of similar adhesive coated plastic dielectric film to protect and insulate the finished circuit. Holes may be punched or drilled in the layers to allow for connections to the finished circuit.

The circuit assembly is then laid up with a protective cap in single or multiple layers (up to 20 plus) and then laminated under heat [(ambient—204°C) (ambient—400 degrees F)] and pressure [(1.72 to 2.75 MPa) (250 to 400 p.s.i.)] taking extreme care to register the circuits and drilled holes. This process is normally performed in a flat bed laminating press by the operator of the press, using pad materials consisting of multiple layers piled on between the steel caul plates and the finished circuit. Typically, the first layer, next to the steel plate, is a non-sticking release material such as a tetrafluoroethylene coated fiberglass cloth. The second layer includes multiple plies of kraft paper or equivalent cellulosic wood product; the third layer consists of one or more plies of a thermoplastic film; and the final layer consists of one or more layers of release materials such as tetrafluoroethylene or polyvinyl fluoride.

The resultant lamelliform pad may include 10 or more loosely piled layers of dissimilar materials, each having two sides presenting up to 20 opportunities for possible contamination. Because each layer is customarily handcut and laid up by hand, there is a high margin for error in the sequencing of dissimilar materials, resulting in defective circuits.

The pads are arranged in a prescribed order on either side of the circuit assembly with the release layer facing the assembly. Multiple circuit assemblies with associated pads are placed in the press to form a book, and the entire book is pressed in one operation to laminate the individual circuit assemblies. When the laminating process is complete the pads are stripped away and the laminated circuit assemblies are removed for further handling.

Among the problems found in the prior art process were erratic results and lamination failures due to errors in selecting and laying up the multiple plies of dissimilar materials, hot spots appearing in the laminate creases, pockets of gas and other contamination trapped in the pad, lateral shifting of the pad materials and the circuit laminate, and moisture absorption by the cellulosic pad.

The US—A—4 264 404 discloses a pressure cushion for use in heat and pressure laminating operations comprising at least two cellulosic sheets and at least one thermoplastic sheet having a glass transition point below 100°C and a melting point of about 125°C or more said thermoplastic sheets being interleaved between the cellulosic paper sheets.

The stratiform sheet of the present invention has its component layers bonded together to form a unified sheet containing:

(a) said polymeric thermoplastic layer as a median layer in which said polymeric thermoplastic material is in film form and has a thickness at the laminating temperature peak at least as great as the differences between the peaks and valleys in the cross-section of the three-dimensional flexible printed circuit;

(b) a polymeric release layer having a thickness of from 2.54 μm to 101.6 μm (0.1 mil to 4 mils) and having an outer surface for releasable disposition against a printed circuit which is being laminated;

(c) an outer polymeric stabilizing layer having a melting point higher than the laminating temperature peak and being formed as an integral part of said unified stratiform sheet in order to prevent lateral movement of said thermoplastic film when in a plastic state in said laminating process; and

(d) adhesive means to bond the component layers in a single, stratiform sheet.

The method of laminating printed circuits under pressure and heat in a flat press according to the present invention comprises the steps of providing a work piece comprising one or more circuit assemblies in need of lamination, providing the stratiform sheets of the present invention arranging each circuit assembly with one of said stratiform sheets on each side to make a book wherein the release layer of each said sheet faces a circuit assembly in the press, and pressing the book.

Such a stratiform sheet achieves substantially more reliable method of preparing the book for the laminating step, and more dependable results.

Further such a stratiform sheet achieves more even and rapid heat distribution with uniform pressure to a printed circuit and a means is provided for minimizing lateral movement of the components of the book in the laminating process and to provide means and methods of reducing the incidence of rejection of the laminated circuit product due to lamination failures.

Yet another object of this invention is to reduce operator error and increase lamination cycle efficiency.

Definitions

As used in this specification, "laminating temperature peak" means the highest temperature attained in the book while in the laminating cycle under consideration; "manufacturing cycle time" means the time from beginning the job of laying up the book for the press through the press cycle time; "press cycle time" means the time elapsed from starting the pressing operation on the book until the time the book is removed from the press to make room for a new book; "melting point" means the transition from solid including glass to liquid; "glass transition point" means the transition between crystalline to plastic (but not liquid) forms.

The polymeric thermoplastic layer may be selected from polyesters, polyvinylchlorides, polyethylenes, polycarbonates, acrylics, ABS and co-polymers of the foregoing materials, in thicknesses ranging from about 101.6 to 381 μm (4 to 15 mils), preferably about 190.5 μm (7.5 mils), and having a glass transition point preferably from about 77°C to 107°C (170 degrees to 225 degrees F).

The polymeric release layer is selected from polyvinylfluorides, polytetrafluoroethylenes, polysiloxanes and other polymers with similar release properties, with a thickness from about 2.54 to 101.6 μm (0.1 mil to 4 mils).

The polymeric stabilizing layer is selected from polyimides, polyesters, polyethersulfones, and preferably, biaxially oriented polyethyleneterephthalates, in thicknesses from about 12.7 to 127 μm (0.5 to 5 mils), preferably, up to about 6.35 to 127 μm (0.25 to 5 mils). The means for joining the layers of the sheet may be extrusion laminating from thermoplastic polymers such as polyethylene or a urethane prepolymeric type adhesive dissolved in suitable solvents, varying in thickness from 2.54 μm to 38.1 μm (0.1 mil to 1.5 mil).

As further assistance, means are provided whereby the release layer side and the stabilizing layer side may be distinguished.

The stratiform sheet is utilized in the method of laminating printed circuits in a flat press by providing a work piece comprising one or more circuit assemblies in need of lamination, providing the stratiform sheets herein specified, and arranging each circuit assembly in a book with one of said stratiform sheets on each side of a circuit assembly with the release layers thereof facing the circuit assemblies in the press, then pressing the book for the press cycle time appropriate to the product and thickness of the book. The method is particularly useful in press cycles using temperatures up to about 204°C (400 degrees F) and at pressures about 1.72 to 2.75 MPa (250 to 400 p.s.i.) in making flexible printed circuits.

Turning now to the drawings in which a typical prior art book and a presently preferred embodiment of the improvements of this invention are represented:

Fig. 1 is a schematic representation of the layering of a book for a flat press, including a single flexible printed circuit assembly and a lamelliform pad, by means of the prior art method;

Fig. 2 is a schematic representation of the arrangement of a book including a single flexible circuit assembly and the stratiform sheet means according to this invention;

Fig. 3 shows a stratiform sheet made according to the teachings of this invention; and

Fig. 4 shows the temperature curve in a typical prior art press cycle and the contrasting temperature curve in a press cycle utilizing this invention.

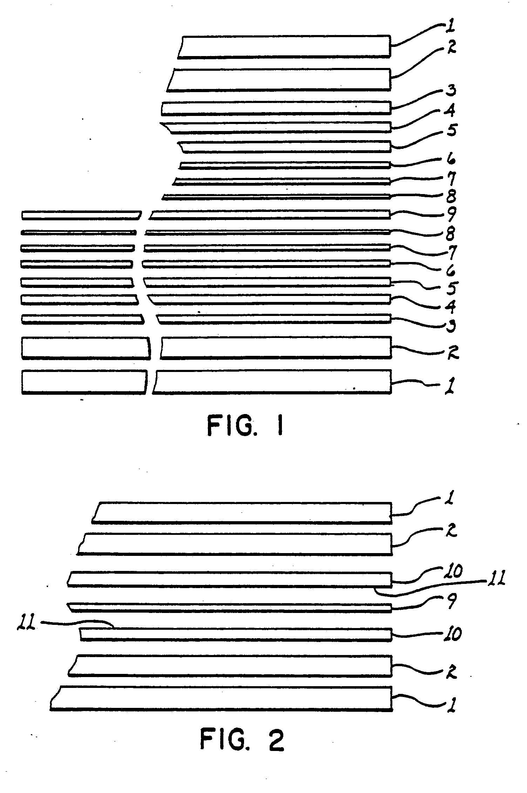

Fig. 1 represents the standard flexible printed circuit industry approach to preparing a book including a flexible printed circuit (a product particularly suited to use of the invention herein) to be laminated in a flat bed press. Between the press platens typically there are disposed, in the following order from top to bottom, a steel-press plate 1, teflon glass cloth 2, multiple layers of kraft paper 3, 4, 5, a 101.6 μm (four-mil) layer of polyethylene 6, a second 101.6 μm (four-mil) layer of polyethylene 7 and a 50.8 μm (two-mil) release film 8 to make a cushion assembly. Then the flexible circuit assembly 9 is inserted and a mirror image (i.e., reverse order) of the arrangement is repeated on the other side of the circuit assembly. The component parts of the flexible printed circuit product, per se, are not shown, it being understood that any suitable flexible, printed circuit assembly to be laminated may become the work piece under consideration.

Multiple stacks of the arrangement between the commonly used glass cloth elements are made to create a book, normally separated by steel plates, and the multiple assemblies are laminated in one pressing.

Many opportunities for error are encountered by press operators in putting together the many layers involved. Errors in selection and sequence of materials are found to be committed by experienced operators. Contamination of the layers is a common hazard. Assemblying the layers by hand may cause creases and create gas pockets. The uneven texture of the cellulosic materials causes hot spots, and the rate of heat distribution and transfer is undesirably low.

Attention is now invited to Fig. 2 wherein a presently preferred embodiment of the improved method and product of this invention are shown: As seen in Fig. 2, the platen 1 and the teflon glass cloth 2 are positioned as in the prior art method, but the elements 3 through 8 of the prior art are replaced in their entirety by a single, unitized laminate pad which is herein referred to as a stratiform sheet 10. The flexible printed circuit assembly 9 (the work piece) is the same. A sheet 10, reversed, is positioned on the second side of the flexible circuit assembly followed by the teflon glass cloth 2 and the steel plate 1 to complete the book. The release layer side 11 of each sheet 10 faces the assembly 9. As in the prior art process, multiple flexible circuit assemblies and pads with additional steel plates are stacked between the two layers of glass cloth 2 to make a complete book to charge the press plate in readiness for laminating.

# 0 174 949

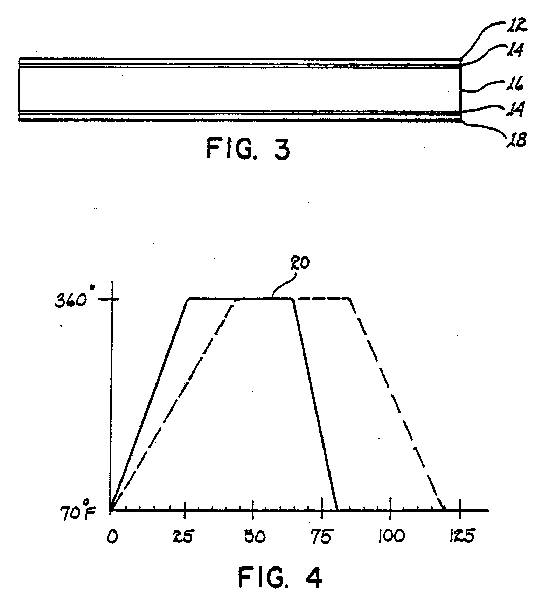

Turning now to Fig. 3, in which an enlarged representation of the pad 10 is shown, layer 12 is a polymeric release layer such as polyvinylfluoride which can be obtained from DuPont Chemical Company under the trademark Tedlar 50AM20LH, which is the presently preferred polymeric release layer. Other suitable materials are polytetrafluoroethylene, which can be obtained from the DuPont Chemical Company under the name Teflon, polysiloxane (silicone) and other polymers with similar release properties. The thickness of layer may vary from 2.54 to 101.6 µm (0.1 mil to 4 mils). At more than 101.6 µm (4 mils) difficulty in conforming to three dimensional products may be experienced.

Layer 14 is a high performance, high temperature adhesive. A presently preferred adhesive may be obtained from Morton Chemical Company under the name Lamal HSA. It is a two-part urethane, prepolymeric adhesive having a solids content of about 70%, dissolved in isopropanol.

Layer 16 is a polymeric thermoplastic layer which is plastic but not melted, and has good conformability at operating temperatures. The presently preferred thermoplastic is a modified polyester in a thickness of 190.5 µm (7.5 mils) which is a co-polyester formed from terephthalic acid and isophthalic acid with cyclohexanedimethanol and which has a glass transition point about 87°C (189 degrees F). It may be obtained from Lustro Plastics Co., Saugus, California, under the designation "A150".

Another layer of adhesive 14 is applied to bond the thermoplastic layer 16 and the polymeric stabilizing layer 18.

Layer 18 is a high temperature polymeric layer that remains stable and retains its chemical and dimensional stability at temperatures above the laminating temperature peak. The melting point is 220°C (429 degrees F). The presently preferred material is biaxially oriented, polyethyleneterephthalate made by American Hoechst Corporation under the mark Hostaphan 5000 in thicknesses about 6.35 µm to 35.56 µm (0.25 mil to 1.4 mil). The function of this layer is to prevent significant lateral movement of the thermoplastic layer 16 when it is in a plastic state.

The function of the thermoplastic layer 16 is to transmit pressure uniformly from the smooth platen to the three dimensional laminate under the conditions of temperature and pressure used to consolidate the laminate. It is necessary that all parts of the encapsulated printed circuit be in intimate contact with the thermosetting plastic (dielectric) which encapsulates it, and that there be no voids or unbonded areas between the circuit and the plastic (dielectric).

A facet of the problem is that if the thermoplastic forming polymer melts and flows freely it may encapsulate and seal the entire book of laminates. According to the practice of this invention, the material selected for layers 16 and 18 will have a melting point above the laminating temperature peak to avoid the liquid state of laminating process temperatures during the press cycle.

If the melt reduces the thermoplastic layer to a thickness that is thinner than the differences between the peaks and valleys in the cross-section of the three dimensional flexible printed circuit the thermoplastic layer loses its ability to conform to the profile of the circuit, and thereby fails in its function of evenly distributing heat and pressure.

Fortuitously, it was discovered that the stabilizing layer solved other problems such as hot spots and poor thermal transmission in the cellulosic material of the prior method.

Normally, the laminating cycle is operated at low pressures for no more than a one hour cycle time, but in some cases the cycle time is substantially longer. In such case a polymer that has longer stability at that operating temperature may be selected for layer 18. A polymer made by DuPont Chemical Company under the trademark Kapton is suitable for the longer cycle time. Other considerations are that the polymers selected should be non-reactive, and that the materials have stability at operating temperatures, to avoid chemical breakdown and significant loss of mechanical properties due to thermal degradation. Other suitable polymers are obtainable from ICI Chemical Company under the trademark Melinex, and from American Hoechst Corporation under the trademark Hostaphan and from DuPont under the trademark Mylar.

Among the other benefits obtained from use of the stratiform sheet of this invention there have been found an absence of creases, entrapped gases and other contaminants, shrinkage is minimized, and a more uniform distribution of heat and pressure is maintained throughout the laminating cycle wherein the thermoplastic layer goes through its glass transition stage and back, attributable, it is thought, to the quick initial conformance with pressure and continued conformance with flow in the thermoplastic layer. The results obtained from the product and method of this invention are more reliable, due to the combination of materials and reduction of operator error.

The use of kraft paper is avoided altogether and, fortuitously, materials have been provided in the preferred embodiment that will cover a broad range of pressing conditions and most of the pressing requirements encountered in the flexible printed circuit art.

As will be explained in greater detail hereafter the stratiform sheets are made by continuous roller process laminating with heat and pressure, whereby the layers of the stratiform sheet are cemented together by adhesives and are rolled and smoothed to make intimate contact, one layer to another, resulting in an absence of air pockets and creases. The process is carried out in a clean room which produces a contamination free product.

Manufacture of stratiform sheet material.

The stratiform sheet material of this invention is manufactured on a continuous web laminating system

4

wherein a suitable adhesive is applied to a roll of the thermoplastic material. It is then passed through an oven to remove the solvent and a release layer is applied to the adhesive layer using a heated nip and the resulting laminate is reversed and suitable adhesive is applied to the other side of the thermoplastic layer. It goes through the oven to remove the solvent, and the stabilizing layer is applied to the second adhesive treated side using a heated laminating nip and the continuous sheeting is collected on another roll. From there it mat be cut to specifically desired sizes suitable for immediate insertion into a book for use in a press, or it may be shipped in roll form to a remote location for processing in that manner. An example of the manufacture of the invention follows.

Example I

To a roll of a co-polyester formed from terephthalic acid and isophthalic acid with cyclohexanedimethanol and whose glass transistion point is 87°C (189 degrees F) and whose sheet thickness is 190.5 μm (7.5 mils) (obtained from Lustro Plastics Co., Saugus, California under its designation A150) there was applied a two-part urethane prepolymeric adhesive (obtained from Morton Chemical Company under the name Lamal HSA) by means of a standard gravure coating head. The coated co-polymer was sent through an oven to remove the solvents from the adhesive and a roll of polyvinylfluoride (obtained from DuPont Chemical Company under the brand name Tedlar 50AM20LH) was laminated to the adhesive-treated side with a hot laminating nip and collected on a second roll.

The second roll was passed through the gravure apparatus again to apply the Lamal adhesive to the opposite side of the A150 co-polymer. The coated sheet was again passed through the oven to remove the solvents and laminated to a roll of polyethylene-teraphthalate (obtained from American Hoechst Company, trademarked Hostaphan 5000), through a hot laminating nip. The resulting stratiform sheet was collected on a roll for storage. At a subsequent time it was formed into pads of a suitable size for inclusion in a book of flexible printed circuit laminates for processing in a flat bed press.

Optionally, the means of manufacture might be a one pass coating operation, and be done with a variety of coating methods such as, for example, Meyer rod, air knife or reverse roll coating offset gravure.

Method of use of the stratiform sheet

The stratiform sheet of this invention replaces multiple layers of dissimilar materials used in the flat bed press method of forming flexible printed circuits under low pressure and heat. Whereas, formerly, the press operator was obliged to cut and lay up as many as 20 different layers of paper and plastic materials in the method of this invention, a single stratiform sheet placed on each side of the circuit assembly will suffice.

In the method of this invention, which is particularly useful in laminating flexible printed circuits in a flat bed press, one or more circuit assemblies are provided as a work piece, a single stratiform sheet is arranged on each side of a circuit assembly with the release layer of each sheet facing a circuit assembly in the press. The book of as many circuit assemblies as desired is arranged in the press between teflon glass cloth layers and steel press plates at each end and between each repetition of circuit assembly and associated stratiform sheets. The book is then pressed at temperatures ranging from room temperature up to about 204°C (400 degrees F), typically about 177°C—193°C (350—380 degrees F) and at pressures between 1.72 to 2.75 MPa (250—400 p.s.i.).

Some of the advantages enjoyed by use of the method utilizing the stratiform sheet is that the time consuming chores of cutting and sequencing the layers at the press are entirely eliminated, resulting in a shorter manufacturing cycle time. The human error encountered in cutting and putting the layers together is avoided and consequently the chances of ruining an expensive work piece is almost entirely eliminated.

Identifying indicia are provided as matte surface on one side of the sheet and smooth on the other side. Examples of the use of product and method of this invention follow.

Example II

A book for press lamination is made up of caul plate, glass cloth, a stratiform sheet of this invention, flexible circuit assembly in need of lamination, stratiform sheet, glass cloth and caul plate, in that order, with the release layers of the stratiform sheets facing the circuit assembly.

A typical circuit assembly was used as the work piece. The stratiform sheet is provided with matte finish on the release layer side and smooth finish on the stabilizing layer side.

The book is assembled at the press site and loaded to a flat bed laminating press. The press cycle is carried out for 80 minutes at 2.0 MPa (300 p.s.i.). The laminating temperature peak is 182°C (360 degrees F). Table 1 is a tabulation of temperature progression against time.

The work piece is removed from the press. Upon examination it is found to be well formed and free of defects.

Example III

To compare the results of the method and product of the invention with the prior art, another run was made using the same circuit assembly as in Example II and a cushion assembled according to present industry practices as illustrated in Fig. 1 of the drawings.

The time versus temperature results from Example III are shown in Table 2.
The combined data are plotted on the time versus temperature curves in Fig. 4 of the drawings.

TABLE 1

| Time: | 0 | 25 min. | 65 min. | 80 min. |
|---|---|---|---|---|
| Temp: | (70 degrees F) 21.1°C | (360 degrees) 182°C | (360 degrees) 182°C | (70 degrees) 21.1°C |

TABLE 2

| Time: | 0 | 45 min. | 85 min. | 120 min. |
|---|---|---|---|---|
| Temp: | (70 degrees F) 21.1°C | (360 degrees) 182°C | (360 degrees) 182°C | (70 degrees) 21.1°C |

Because there is no longer a need for purchasing dissimilar materials and storing them at the plant, the logistics of purchasing, transporting, collecting and storing multiple inventories are simplified, with a consequent savings of time and money and space. Greater consistency in the pressing process is obtained by using certain materials. In the stratiform sheets of this invention the materials have been selected to cover a broad range of circuit design requirements thereby reducing the need for ad hoc selections of materials for laminating flexible printed circuits. Furthermore, the floor space now required in the prior art for cutting, assembling and storing the pads at or near the press site (after the materials are removed from the warehouse) has also been avoided.

**Claims**

1. A stratiform sheet (10) for use in the flat press method of laminating three-dimensional printed circuits comprising a polymeric thermoplastic layer (16) having a glass transistion point lower than the laminating temperature peak and a melting point higher than the laminating temperature peak, said stratiform sheet having its component layers bonded together to form a unified sheet containing:
(a) said polymeric thermoplastic layer (16) as a median layer in which said polymeric thermoplastic material is in film form and has a thickness at the laminating temperature peak at least as great as the differences between the peaks and valleys in the cross-section of the three-dimensional flexible printed circuit;
(b) a polymeric release layer (12) having a thickness of from 2.54 μm to 101.6 μm (0.1 mil to 4 mils) and having an outer surface for releasable disposition against a printed circuit which is being laminated;
(c) an outer polymeric stabilizing layer (18) having a melting point higher than the laminating temperature peak and being formed as an integral part of said unified stratiform sheet in order to prevent lateral movement of said thermoplastic film when in a plastic state in said laminating process; and
(d) adhesive means (14) to bond the component layers in a single stratiform sheet.

2. The stratiform sheet according to claim 1 characterized in that said polymeric thermoplastic layer (16) is selected from polyvinylchlorides, polyethylenes, polycarbonates, acrylics, ABS, polyesters and co-polymers thereof; said polymeric release layer is selected from polyvinylfluorides, polytetrafluoroethylenes, and polysiloxanes, and said polymeric stabilizing layer (18) is selected from polyesters, polyethersulfones, biaxially oriented polyethyleneterephthalates and polyimides.

3. The stratiform sheet according to claim 1 characterized in that said adhesive (14) is a two-part urethane prepolymeric adhesive.

4. The stratiform sheet according to claim 1 characterized in that said adhesive (14) is a thermoplastic resin selected from extrudable polyethylene and polypropylene.

5. The stratiform sheet according to claim 1, characterized in that the means for joining said layers is by extrusion lamination with thermoplastic polymers.

6. The stratiform sheet according to claim 1 characterized by the addition of means for distinguishing the release layer side from the stabilizing layer side to prevent inadvertant reversal in use.

7. The stratiform sheet according to claim 1 characterized in that the glass transition point of said thermoplastic polymer is from 77°C to 107°C (170 degrees F to about 225 degrees F).

8. The stratiform sheet according to claim 1 characterized in that the glass transition point of said thermoplastic layer is 87°C (189 degrees F).

9. A stratiform sheet according to claims 1 and 2 characterized in that
(a) said outer layer (18) has a thickness between 6.35 to 127 μm (0.25 to 5 mils);
(b) said temperature responsive median layer (16) has a thickness from 101.6 μm and 381 μm (4 mils and 15 mils);
(c) said inner release film (12) has a thickness from 2.54 μm to 101.6 μm (0.1 mil to 4 mils);

(d) said adhesive means (14) for bonding said layers to each other in the order given are selected from compatible polymeric adhesives; and

(e) comprising means for distinguishing the outer (18) and inner (12) layer to prevent inadvertant reversal of layers from the correct sequence in use.

10. The stratiform sheet according to claim 9 characterized in that said outer (18) layer is a biaxially oriented polyethyleneterephthalate, said inner layer (12) is polyvinylfluoride, said median layer (16) is a co-polyester formed from terephthalic acid and isophthalic acid with cyclohexanedimethanol in a thickness of 190.5 μm (7.5 mils) and said adhesive (14) is a two-part urethane prepolymeric adhesive.

11. The stratiform sheet according to claim 9 characterized in that said means for distinguishing the outer (18) and inner (12) layers thereof is a smooth finish on one side of said sheet and a matte finish on the other side of said sheet.

12. A method of laminating printed circuits under pressure and heat in a flat press, comprising the steps of providing a work piece comprising one or more circuit assemblies (9) in need of lamination, providing the stratiform sheets (10) of claims 1—11, arranging each circuit assembly (9) with one of said stratiform sheets (10) on each side to make a book wherein the release layer (12) of each said sheet (10) faces a circuit assembly (9) in the press, and pressing the book.

13. The method according to claim 12 characterized in that the circuit laminating step is carried out at temperatures ranging from ambient to about 193°C (380 degrees F) and at a pressure from 1.72 to 2.75 MPa (250 p.s.i. to about 400 p.s.i.), for one hour.

14. A charge of material for a flat bed press pad useful in printed circuit lamination comprising a printed circuit assembly and a stratiform sheet according to claims 1—11.

## Patentansprüche

1. Schichtplatte (10) zur Verwendung beim Flachpreßverfahren zum Laminieren von dreidimensionalen gedruckten Schaltungen, mit einer polymeren thermoplastischen Schicht (16), die einen Einfrierpunkt hat, der niedriger als die Laminiertemperaturspitze ist, und einen Schmelzpunkt, der höher als die Laminiertemperaturspitze ist, wobei die Teilschichten der Schichtplatte miteinander verklebt sind, um eine vereinheitliche Platte zu bilden, beinhaltend:

a) die polymere thermoplastische Schicht (16) als eine Mittelschicht, in der das polymere thermoplastische Material in Filmform vorliegt und eine Dicke bei der Laminiertemperaturspitze hat, die wenigstens so groß wie die Differenzen zwischen den Spitzen und Tälern im Querschnitt der dreidimensionalen biegsamen gedruckten Schaltung ist;

b) eine polymere Trennschicht (12), die eine Dicke von 2,54 μm bis 101,6 μm (0.1 mil bis 4 mils) und eine äußere Oberfläche zur trennbaren Anordnung an einer gedruckten Schaltung, die laminiert wird, hat;

c) eine äußere polymere Stabilisierschicht (18), die einen Schmelzpunkt hat, der höher als die Laminiertemperaturspitze ist, und als ein integraler Bestandteil der vereinheitlichten Schichtplatte ausgebildet ist, um eine seitliche Bewegung des thermoplastischen Films zu verhindern, wenn er sich in dem Laminierprozeß in einem plastischen Zustand befindet; und

d) einen Klebstoff (14) zum Verkleben der Teilschichten in einer einzelnen Schichtplatte.

2. Schichtplatte nach Anspruch 1, dadurch gekennzeichnet, daß die polymere thermoplastische Schicht (16) ausgewählt wird unter Polyvinylchloriden, Polyethylenen, Polycarbonaten, Acrylharzen, ABS, Polyestern und Copolymeren derselben; die polymere Trennschicht ausgewählt wird unter Polyvinylfluoriden, Polytetrafluorethylenen und Polysiloxanen, und die polymere Stabilisierschicht (18) ausgewählt wird unter Polyestern, Polyethersulfonen, biaxial orientierten Polyethylenterephthalaten und Polyimiden.

3. Schichtplatte nach Anspruch 1, dadurch gekennzeichnet, daß der Klebstoff (14) ein Zweikomponenten-Urethanvorpolymerklebstoff ist.

4. Schichtplatte nach Anspruch 1, dadurch gekennzeichnet, daß der Klebstoff (14) ein thermoplastisches Harz ist, das unter extrudierbarem Polyethylen und Polypropylen ausgewählt wird.

5. Schichtplatte nach Anspruch 1, dadurch gekennzeichnet, daß die Maßnahme zum Verbinden der Schichten aus Extrusionsbeschichten mit thermoplastischen Polymeren besteht.

6. Schichtplatte nach Anspruch 1, gekennzeichnet durch das Hinzufügen einer Einrichtung zum Unterscheiden der Trennschichtseite von der Stabilisierungsschichtseite, um ein unabsichtliches Vertauschen im Gebrauch zu verhindern.

7. Schichtplatte nach Anspruch 1, dadurch gekennzeichnet, daß der Einfrierpunkt des thermoplastischen Polymers von 77°C bis 107°C (170°F bis etwa 225°F) beträgt.

8. Schichtplatte nach Anspruch 1, dadurch gekennzeichnet, daß der Einfrierpunkt der thermoplastischen Schicht 87°C (189°F) ist.

9. Schichtplatte nach den Ansprüchen 1 und 2, dadurch gekennzeichnet, daß

a) die äußere Schicht (18) eine Dicke zwischen 6,35 bis 127 μm (0,25 bis 5 mils) hat;

b) die temperaturempfindliche Mittelschicht (16) eine Dicke von 101,6 μm bis 381 μm (4 mils und 15 mils) hat;

c) der innere Trennfilm (12) eine Dicke von 2,54 μm bis 101,6 μm (0,1 mil bis 4 mils) hat;

d) der Kelbstoff (14) zum Miteinanderverkleben der Schichten in der gegebenen Reihenfolge unter kompatiblen polymeren Klebstoffen ausgewählt wird; und

e) beinhaltend eine Einrichtung zum Unterscheiden der äußeren (18) und der inneren (12) Schicht, um ein unabsichtliches Vertauschen der Schichten gegenüber der korrekten Reihenfolge im Gebrauch zu verhindern.

10. Schichtplatte nach Anspruch 9, dadurch gekennzeichnet, daß die äußere (18) Schicht ein biaxial orientiertes Polyethylenterephthalat ist, daß die innere Schicht (12) Polyvinylfluorid ist, daß die Mittelschicht (16) ein Copolyester ist, gebildet aus Terephthalsäure und Isophthalsäure mit Cyclohexandimethanol in einer Dicke von 190,5 µm (7,5 mils) und daß der Klebstoff (14) ein Zweikomponenten-Urethanvorpolymerklebstoff ist.

11. Schichtplatte nach Anspruch 9, dadurch gekennzeichnet, daß die Einrichtung zum Unterscheiden der äußeren (18) und der inneren (12) Schichten derselben eine glatte Oberfläche auf einer Seite der Platte und eine matte Oberfläche auf der anderen Seite der Platte ist.

12. Verfahren zum Laminieren von gedruckten Schaltungen unter Druck und Hitze in einer Flachpresse, beinhaltend die Schritte, ein Werkstück vorzusehen, das eine oder mehrere Schaltungsanordnungen (9) umfaßt, die zu laminieren sind, die Schichtplatten (10) nach den Ansprüchen 1—11 vorzusehen, jede Schaltungsanordnung (9) mit einer der Schichtplatten (10) auf jeder Seite anzuordnen, um ein Buch herzustellen, wobei die Trennschicht (12) jeder Platte (10) einer Schaltungsanordnung (9) in der Presse zugewandt ist, und das Buch zu pressen.

13. Verfahren nach Anspruch 12, dadurch gekennzeichnet, daß der Schaltungslaminierschritt bei Temperaturen ausgeführt wird, die von Umgebungstemperatur bis etwa 193°C (380°F) reichen, und bei einem Druck von 1,72 bis 2,75 MPa (250 p.s.i. bis etwa 400 p.s.i.), und zwar für eine Stunde.

14. Materialcharge für einen Flachbettpreßblock, der beim Laminieren von gedruckten Schaltungen brauchbar ist, welches eine gedruckte Schaltungsanordnung und eine Schichtplatte nach den Ansprüchen 1—11 beinhaltet.

## Revendications

1. Feuille (10) contenant des couches et destinée à être utilisée dans le procédé faisant appel à une presse à plateaux pour la lamification de circuits imprimés à trois dimensions comprenant une couche polymère thermoplastique (16) ayant un point de vitrification inférieur à la température maximale de lamification et un point de fusion supérieur à cette dernière, cette feuille contenant des couches comportant, comme couches constitutives liées ensemble pour former une feuille unifiée:

(a) la couche polymère thermoplastique (16) précitée comme couche médiane dans laquelle la matière polymère thermoplastique est sous forme d'une pellicule et a, à la température maximale de lamification, une épaisseur au moins égale aux différences existant entre les crêtes et les creux de la section transversale du circuit imprimé flexible à trois dimensions;

(b) une couche polymère de séparation (12) ayant une épaisseur de 2,54 µm à 101,6 µm (0,0001 à 0,004 pouce) et comportant une surface extérieure disposée de manière séparable contre un circuit imprimé qui doit être lamifié;

(c) une couche stabilisatrice polymère extérieure (18) ayant un point de fusion supérieur à la température maximale de lamification et faisant partie intégrante de la feuille unifiée contenant des couches afin d'empêcher le mouvement latéral de cette pellicule thermoplastique lorsqu'elle est à l'état plastique dans ce procédé de lamification; et

(d) un moyen adhésif (14) en vue de lier les couches constitutives en une seule feuille contenant des couches.

2. Feuille contenant des couches selon la revendication 1, caractérisée en ce que la couche polymère thermoplastique (16) est choisie parmi les chlorures de polyvinyle, les polyéthylènes, les polycarbonates, les résines acryliques, le copolymère d'acrylonitrile/butadiène/styrène, les polyesters et leurs copolymères, cette couche polymère de séparation étant choisie parmi les fluorures de polyvinyle, les polytétrafluoréthylènes et les polysiloxanes, tandis que la couche stabilisatrice polymère (18) est choisie parmi les polyesters, les polyéther-sulfones, les polyimides et les téréphtalates de polyéthylène soumis à une orientation biaxiale.

3. Feuille contenant des couches selon la revendication 1, caractérisée en ce que l'adhésif (14) est un adhésif prépolymère d'uréthane en deux parties.

4. Feuille contenant des couches selon la revendication 1, caractérisée en ce que l'adhésif (14) est une résine thermoplastique choisie parmi le polypropylène et le polyéthylène pouvant être extrudés.

5. Feuille contenant des couches selon la revendication 1, caractérisée en ce que les couches précitées sont réunies moyennant une lamification par extrusion avec des polymères thermoplastiques.

6. Feuille contenant des couches selon la revendication 1, caractérisée en ce qu'on prévoit, en outre, un moyen en vue de distinguer la face comportant la couche de séparation de la face comportant la couche de stabilisation af'in d'empêcher une inversion par inadvertance lors de l'utilisation.

7. Feuille contenant des couches selon la revendication 1, caractérisée en ce que le point de vitrification du polymère thermoplastique se situe entre 77°C et 107°C (170°F et environ 225°F).

8. Feuille contenant des couches selon la revendication 1, caractérisée en ce que le point de vitrification de la couche thermoplastique est de 87°C (189°F).

9. Feuille contenant des couches selon les revendications 1 et 2, caractérisée en ce que:

(a) la couche extérieure (18) a une épaisseur comprise entre 6,35 et 127 µm (0,00025 et 0,005 pouce);

(b) la couche médiane (16) réagissant à la température a une épaisseur se situant entre 101,6 µm et 381 µm (0,004 et 0,015 pouce);

(c) la pellicule intérieure de séparation (12) a une épaisseur se situant entre 2,54 µm et 101,6 µm (0,0001 et 0,004 pouce);

(d) les moyens adhésifs (14) en vue de lier les couches l'une à l'autre, dans l'ordre indiqué, sont choisi parmi des adhésifs polymères compatibles, et

(e) un moyen étant prévu pour établir une distinction entre la couche extérieure (18) et la couche intérieure (12) afin d'empêcher une inversion des couches par inadvertance vis-à-vis de leur séquence correcte lors de l'utilisation.

10. Feuille contenant des couches selon la revendication 9, caractérisée en ce que la couche extérieure (18) est constituée de téréphtalate de polyéthylène soumis à une orientation biaxiale, la couche intérieure (12) est constituée de fluorure de polyvinyle, la couche médiane (16) est constituée d'un copolyester formé à partir d'acide téréphtalique et d'acide phtalique avec du cyclohexane-diméthanol en une épaisseur de 190,5 µm (0,0075 pouce), tandis que l'adhésif (14) est un adhésif prépolymère d'uréthane en deux parties.

11. Feuille contenant des couches selon la revendication 9, caractérisée en ce que le moyen permettant d'établir une distinction entre la couche extérieure (18) et la couche intérieure (12) est un fini lisse sur une face de cette feuille et un fini mat, sur l'autre face de cette dernière.

12. Procédé de lamification de circuits imprimés sous pression et à la chaleur dans une presse à plateaux, caractérisé en ce qu'il comprend les étapes qui consistent à prévoir une pièce à usiner comportant un ou plusieurs assemblages de circuits (9) nécessitant une lamification, prévoir les feuilles (10) contenant des couches selon les revendications 1 à 11, disposer chaque assemblage de circuit (9) avec une de ces feuilles (10) contenant des couches sur chaque face afin de former un livre dans lequel la couche de séparation (12) de chaque face (10) est tournée vers un assemblage de circuit (9) dans la presse, puis presser le livre.

13. Procédé selon la revendication 12, caractérisé en ce que l'étape de lamification de circuit est effectuée à des températures comprises entre la température ambiante et environ 193°C (380°F) et sous une pression comprise entre 1,72 et 2,75 MPa (250 à environ 400 livres/pouce carré), pendant une heure.

14. Charge de matière pour un coussin d'une presse à plateaux, utile dans la lamification de circuits imprimés, comprenant un assemblage de circuit imprimé et une feuille contenant des couches selon les revendications 1 à 11.

FIG. 1

FIG. 2

0 174 949

FIG. 3

FIG. 4